# EUROPEAN PATENT SPECIFICATION

(11) **EP 2 928 276 B1**
(45) Date of publication and mention of the grant of the patent: **01.11.2017**
(21) Application number: 15159280.5
(22) Date of filing: 16.03.2015
(51) Int. Cl.: H05K 7/20

(54) **COOLING FLOW OPTIMIZATION**
KÜHLKREISLAUFOPTIMIERUNG
OPTIMISATION D'ÉCOULEMENT DE REFROIDISSEMENT

(30) Priority: 20.03.2014 US 201414220274
(43) Date of publication of application: 07.10.2015
(73) Proprietor: Hamilton Sundstrand Corporation, Windsor Locks, CT 06096-1010 (US)
(72) Inventor: Pal, Debabrata, Hoffman Estates, Illinois 60195 (US)
(74) Representative: Leckey, David Herbert

(56) References cited:
- US-A1- 2008 205 004
- US-B1- 6 330 155

## Description

### BACKGROUND

Power distribution in aircraft often employs a series of printed wiring boards housed within a remote power unit. The power unit supplies power to each of the printed wiring boards, for example via a backplane. The printed wiring boards can contain circuitry to modify power output to any of a variety of applications requiring electricity throughout the aircraft.

Printed wiring boards dissipate some power as heat when routing electricity to a load elsewhere in the aircraft. In some cases, power dissipation of a printed wiring board can be as high as 20 to 60 Watts. The functionality and longevity of the printed wiring boards depends on adequate heat dissipation from the printed wiring boards. For this reason, cooling air is often routed through the power unit, and is directed around each of the printed wiring boards to provide cooling.

Such air cooling satisfactorily cools the printed wiring boards, but introduces inefficiency. For example, a subset of the devices powered by the printed wiring boards may be off at any given time. Those printed wiring boards configured to route power to a device that is powered down will not dissipate heat. Nonetheless, known air cooling systems route cooling air past those printed wiring boards. It is desirable to reduce the quantity of pressurized cooling air needed by the power unit, and cool only those printed wiring boards that are hot.

US 6330155 B1 discloses an enclosure for electronic equipment in which cooling air is admitted to channels containing circuit boards. Each channel is provided with a thermally sensitive blocker door having a bimetallic coil actuator. US 2008/0205004 A1 discloses a cooling arrangement having a temperature sensitive air flow regulator.

### SUMMARY

From a first aspect, the invention provides a remote power unit as set forth in claim 1. The invention also provides a method for cooling a printed wiring board, as set forth in claim 4.

### BRIEF DESCRIPTION OF THE DRAWINGS

Fig. 1 is a cutaway perspective view of a remote power unit.
Fig. 2 is a cross-sectional view of the remote power unit of Fig. 1.
Fig. 3 is an exploded perspective view of a pair of slots each holding a printed wiring board and attached to a door.
Fig. 4 is a cross-sectional view of a slot and attached door.
Fig. 5 is a perspective view of an electrical connection between a printed wiring board and a hinge.

### DETAILED DESCRIPTION

A remote power unit contains several printed wiring boards (PWBs) that route power to loads throughout an aircraft or other system. The PWBs generate heat when delivering power to those loads, and cooling is required to prevent damage or failure that could be caused by overheating. A shape thermal memory alloy is used to open and close doors in the flowpath of a cooling airflow. As each PWB generates sufficient heat, that heat causes the shape memory element to open the door, and cooling airflow is routed along the PWB. Conversely, as the PWB cools, for example if it ceases delivering power to its corresponding remote load(s), the shape memory element closes the door and cooling airflow is blocked. This system reduces the use of cooling air, delivering cooling air only to those PWBs that are in need of cooling.

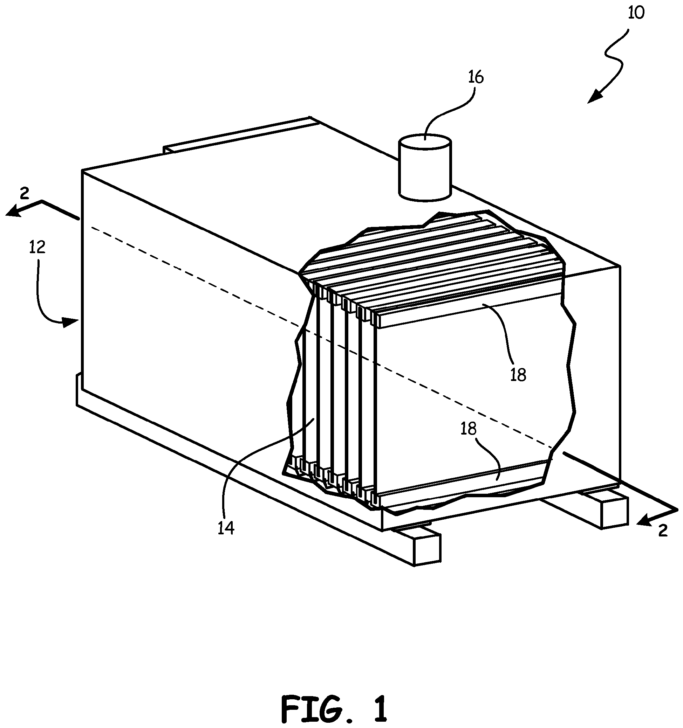

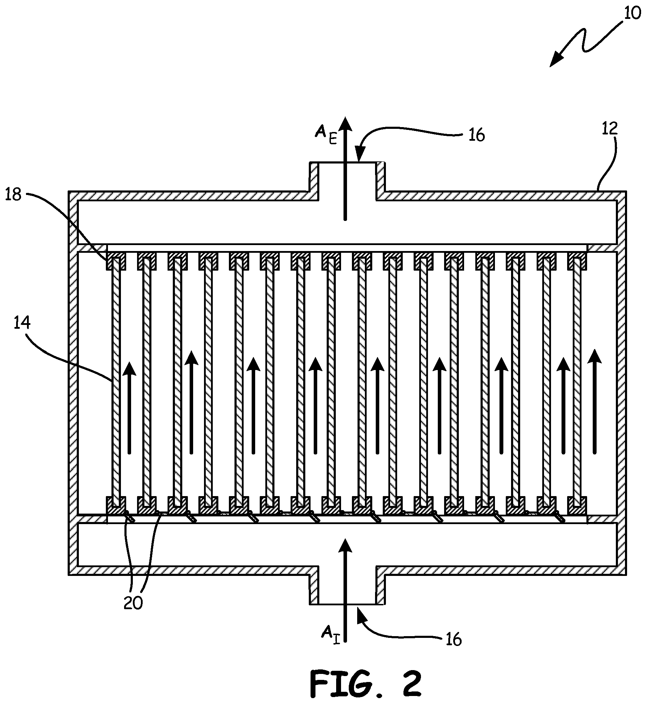

Figs. 1-2 show remote power unit 10, which includes housing 12, PWBs 14, duct 16, slots 18, and doors 20. Fig. 1 is a cutaway perspective view of remote power unit 10. Fig. 2 is a cross-sectional view of remote power unit 10 taken along line 2-2 of Fig. 1.

Remote power unit 10 can be used in a variety of applications. In one embodiment, remote power unit 10 can be used to distribute power to various remote loads (not shown) in an aircraft. For example, various sensors, actuators, communication equipment, and/or other loads can be powered by remote power unit 10.

Housing 12 provides an outer shell for remote power unit 10. In Fig. 1, housing 12 is cut away to show the components housed therein. Housing 12 may include components to receive power from an external power source (not shown) and distribute that power to components it houses. For example, a gas turbine engine and associated generator may provide electric power to housing 12.

PWBs 14 are arranged within housing 12. As previously discussed, PWBs 14 are associated with one or more external loads (not shown). PWBs 14 are configured to receive electrical power through a backplane or other connection (not shown) and selectively route electrical power to associated loads only when needed. PWBs 14 generate some heat, typically as a result of power dissipation in the range of 20-60W, while delivering power to one or more loads. When PWBs 14 are not delivering power to a load, they generate little or no heat.

Ducts 16 are arranged on housing 12, and provide access to the interior of remote power unit 10. One of ducts 16 is configured to allow inlet airstream A_{I} to enter housing 12. Similarly, one of ducts 16 is configured to allow egress airstream A_{E} to leave housing 12.

Slots 18 are positioned throughout housing 12 and are configured to receive PWBs 14. Slots 18 are substantially evenly spaced throughout housing 12. Slots 18 are in thermal contact with PWBs 14, such that as each PWB 14 heats up, the corresponding slot(s) 18 holding that PWB 14 are also heated.

Doors 20 are positioned on slots 18. In the embodiment shown, doors 20 are positioned on those slots 18 that are closer to duct 16 that contains inlet airstream A_{I} than their associated PWB 14 is. Doors 20 are positioned such that, in a closed configuration, the cooling air airstream is blocked. In the opened position, as indicated by arrows in Fig. 2, doors 20 permit a cooling airstream to pass along the corresponding PWB 14.

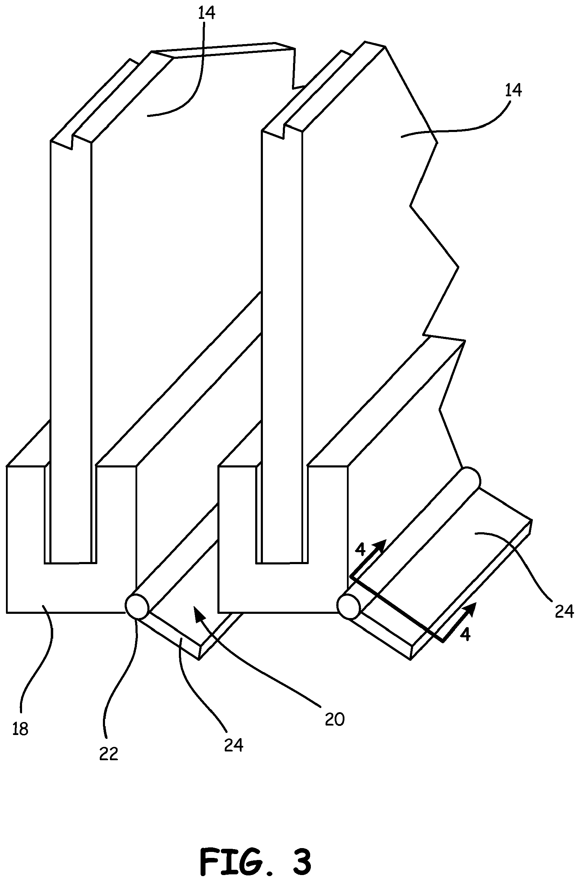

Some of doors 20 are at least partially open while others are closed, as shown in Fig. 2. In operation, some but not all of PWBs 14 are delivering power to a remote load at any given time. Those PWBs 14 that are delivering power generate heat, which causes doors 20 to open, as described in more detail with respect to Figs. 3-5.

Fig. 3 is an exploded perspective view of a pair of slots 18 each holding a PWB 14 and attached to door 20. Door 20 includes hinge 22 and blocker 24.

Hinge 22 is a shape memory alloy hinge. For example, hinge 22 could be made of a Nitinol (nickel/titanium) alloy. Hinge 22 is thermally coupled with slot 18, which is in turn thermally coupled to PWB 14.

Blocker 24 is configured to be movable between a closed position and an open position. In the closed position, blocker 24 closes off the space between the adjacent slots 18. In the open position, blocker 24 permits cooling air to flow between adjacent slots 18.

Hinge 22 is affixed to slot 18 and blocker 24. Because hinge 22 is a shape memory element, it may change shape or size depending on the temperature. Below its transition temperature, hinge 22 has a shape and size that results in blocker 24 being interposed between adjacent slots 18 (i.e., blocking cooling air from passing between adjacent slots 18). Above its transition temperature, hinge 22 has a shape and size that does not cause blocker 24 to block the space between slots 18 (i.e., cooling air is routed between adjacent slots 18).

Opening and closing door 20 based on the temperature of its associated PWB 14 prevents waste of cooling air. By only opening those doors 20 that are associated with a PWB 14 above a threshold temperature, cooling air is delivered only to those PWBs 14 that need cooling, and draw of conditioned bleed air is minimized.

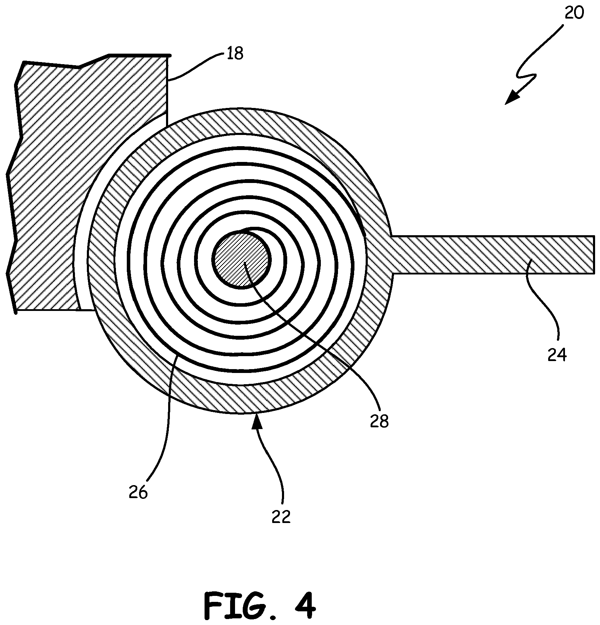

Fig. 4 is a cross-sectional view of a part of slot 18, as well as its corresponding door 20. Door 20 includes hinge 22 and blocker 24. The cross-section of Fig. 4 shows a part of hinge 22 that includes shape memory spring 26 and pin 28. As shown in Fig. 4, shape memory spring 26 is below its transition temperature and blocker 24 is in the closed position.

As previously described with respect to Figs. 2-3, shape memory spring 26 is a shape memory element that is configured to open or close blocker 24. Shape memory spring 26 increases in length as its temperature increases above a transition temperature. As shown in Fig. 4, shape memory spring 26 is affixed to pin 28, which is stationary relative to slot 18. As shape memory spring 26 increases in length, blocker 24 is forced clockwise around pin 28 into the open position. This process is reversible; by subsequently cooling shape memory spring 26 below its transition temperature, blocker is pulled counterclockwise around pin 28 into the closed position.

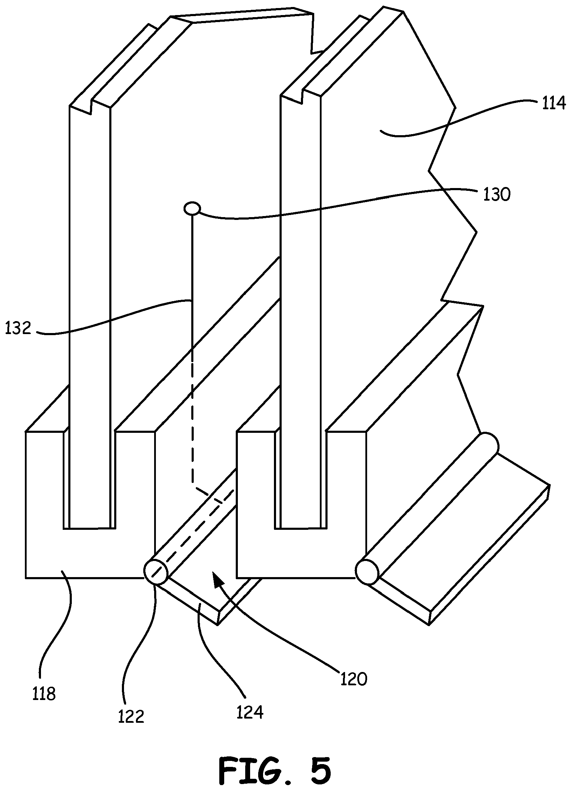

Fig. 5 is a perspective view of another embodiment of a cooling air blocking system. Fig. 5 shows a pair of printed wiring boards 114 each captured by a slot 118. Doors 120 each include a hinge 122 and a blocker 124. The embodiment illustrated in Fig. 5 also includes power source 130 and lead 132. Power source 130 delivers electricity to lead 132 when PWB 114 is delivering power to a remote load. Power source 130 supplies power to lead 132 when commanded by a temperature sensing and control circuit (not shown). For example, a temperature sensing and control unit may include at least one temperature sensor in the remote power unit, and a control circuit.

Lead 132 delivers that electricity to hinge 122, where it is used to operate blocker 124. Electricity dissipated in the form of heat via resistive heating causes the thermal transition in a shape memory element, as described previously.

Power source 130 delivers power to hinge 122 via lead 132 when current is flowing through PWB 114. In alternative embodiments, power source 130 may deliver power to hinge 122 when PWB 114 exceeds a certain temperature. In certain embodiments, some of the PWBs 114 may have temperature controlled door features (as previously described with respect to Figure 3), while other PWBs 114 may have door features (as previously described with respect to Figure 5), arranged within a single remote power unit.

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A remote power unit (10) comprising:
an inlet duct (16) arranged on a housing (12) and configured to receive cooling air;
a plurality of slots (18; 118) each configured to hold a printed wiring board (14; 114);
a plurality of printed wiring boards (14; 114) held in at least some of the plurality of slots (18;118);
an outlet duct (16) arranged opposite the printed wiring boards (14;114) from the inlet duct (16), forming a path for cooling air to flow from the inlet duct (16) along the printed wiring boards (14;114) to the outlet duct (16); and
a plurality of doors (20; 120) each having a shape memory element (26), each of the doors (20; 120) arranged on one of the plurality of slots (18;118);
wherein the shape memory element (26) is a thermal shape memory element (26) having a transition temperature, each of the shape memory elements (26) comprising a shape memory coil, the shape memory coil being a hinge (22; 122);
wherein the plurality of doors (20; 120) are configured to be in the open position to allow a cooling air stream to flow around the printed wiring board (14; 114) when the shape memory element (26) is above a transition temperature, and the plurality of doors (20; 120) are configured to be in the closed position when the shape memory element is below its transition temperature;
and further comprising a lead (132) connecting each of the shape memory elements (26) to a power source, wherein the power source (130) is configured to deliver power to the shape memory element (26) via the lead (132) when an associated printed wiring board (14; 114) exceeds a threshold temperature, and/or wherein the power source (130) is configured to deliver power to the shape memory element (26) via the lead (132) when the printed wiring board (14; 114) delivers power to a remote load, and wherein powering the lead (132) causes resistive heating of the shape memory element (26).

2. The remote power unit (10) of claim 1, wherein each of the shape memory elements (26) comprises a nickel/titanium alloy.

3. The remote power unit (10) of claim 1 or 2, wherein each of the shape memory elements (26) is in thermal contact with an associated printed wiring board (14; 114).

4. A method for cooling a printed wiring board (14; 114) housed in a remote power unit (10) as set forth in any preceding claim, the method comprising:
providing a cooling airstream within the remote power unit (10);
distributing power via the printed wiring board (14; 114); and
powering the lead (132) connected to the shape memory element (26) to allow the cooling airstream to flow around the printed wiring board (14; 114) when an associated printed wiring board (14; 114) exceeds a threshold temperature and/or when the printed wiring board (14;114) delivers power to a remote load.

## Patentansprüche

1. Remote-Leistungseinheit (10), umfassend:
einen Einlasskanal (16), der an einem Gehäuse (12) angeordnet und dazu konfiguriert ist, Kühlluft aufzunehmen;
eine Vielzahl von Schlitzen (18; 118), die jeweils dazu konfiguriert sind, eine gedruckte Leiterplatte (14; 114) zu halten;
eine Vielzahl gedruckter Leiterplatten (14; 114), die in wenigstens einigen der Vielzahl von Schlitzen (18; 118) gehalten werden;
einen Auslasskanal (16), der in Bezug auf den Einlasskanal (16) gegenüber den gedruckten Leiterplatten (14; 114) angeordnet ist, wodurch ein Weg zum Strömen von Kühlluft vom Einlasskanal (16) an den gedruckten Leiterplatten (14; 114) entlang zum Auslasskanal (16) gebildet wird; und
eine Vielzahl von Türen (20; 120), die jeweils ein Formgedächtniselement (26) aufweisen, wobei die einzelnen Türen (20; 120) jeweils an einem der Vielzahl von Schlitzen (18; 118) angeordnet sind;
wobei das Formgedächtniselement (26) ein Wärmeformgedächtniselement (26) mit einer Übergangstemperatur ist, wobei die einzelnen Formgedächtniselemente (26) jeweils eine Formgedächtnisspule umfassen, wobei die Formgedächtnisspule ein Scharnier (22; 122) ist;
wobei die Vielzahl von Türen (20; 120) dazu konfiguriert ist, in der offenen Stellung zu sein, um einen Kühlungsluftstrom um die gedruckte Leiterplatte (14; 114) strömen zu lassen, wenn das Formgedächtniselement (26) über einer Übergangstemperatur ist, und die Vielzahl von Türen (20; 120) dazu konfiguriert ist, in der geschlossenen Stellung zu sein, wenn das Formgedächtniselement unter seiner Übergangstemperatur ist;
und ferner umfassend eine Leitung (132), die die einzelnen Formgedächtniselemente (26) mit einer Leistungsquelle verbindet, wobei die Leistungsquelle (130) dazu konfiguriert ist, über die Leitung (132) Leistung an das Formgedächtniselement (26) abzugeben, wenn eine zugehörige gedruckte Leiterplatte (14; 114) eine Schwellentemperatur übersteigt, und/oder wobei die Leistungsquelle (130) dazu konfiguriert ist, über die Leitung (132) Leistung an das Formgedächtniselement (26) abzugeben, wenn die gedruckte Leiterplatte (14; 114) Leistung an eine Remote-Last abgibt, und wobei das Versorgen der Leitung (132) mit Leistung eine Widerstandserwärmung des Formgedächtniselements (26) bewirkt.

2. Remote-Leistungseinheit (10) nach Anspruch 1, wobei die einzelnen Formgedächtniselemente (26) jeweils eine Nickel/Titan-Legierung umfassen.

3. Remote-Leistungseinheit (10) nach Anspruch 1 oder 2, wobei die einzelnen Formgedächtniselemente (26) jeweils in Wärmekontakt mit einer zugehörigen gedruckten Leiterplatte (14; 114) stehen.

4. Verfahren zum Kühlen einer gedruckten Leiterplatte (14; 114), die in einer Remote-Leistungseinheit (10) nach einem der vorangehenden Ansprüche aufgenommen ist, wobei das Verfahren Folgendes umfasst:
Bereitstellen eines Kühlungsluftstroms in der Remote-Leistungseinheit (10);
Verteilen von Leistung über die gedruckte Leiterplatte (14; 114); und
Versorgen der Leitung (132), die mit dem Formgedächtniselement (26) verbunden ist, mit Leistung, um den Kühlungsluftstrom um die gedruckte Leiterplatte (14; 114) strömen zu lassen, wenn eine zugehörige gedruckte Leiterplatte (14; 114) eine Schwellentemperatur übersteigt und/oder wenn die gedruckte Leiterplatte (14; 114) Leistung an eine Remote-Last abgibt.

## Revendications

1. Unité d'alimentation distante (10) comprenant :
un conduit d'entrée (16) agencé sur un boîtier (12) et configuré pour recevoir de l'air de refroidissement ;
une pluralité de fentes (18 ; 118) chacune configurée pour maintenir une plaquette de circuit imprimé (14 ; 114) ;
une pluralité de plaquettes de circuit imprimé (14 ; 114) maintenue dans au moins une partie de la pluralité de fentes (18 ; 118) ;
un conduit de sortie (16) disposé à l'opposé des plaquettes de circuit imprimé (14 ; 114) depuis le conduit d'entrée (16), formant un trajet pour l'air de refroidissement pour s'écouler du conduit d'entrée (16) le long des plaquettes de circuit imprimé (14 ; 114) au conduit de sortie (16) ; et
une pluralité de portes (20 ; 120) chacune ayant un élément de mémoire de forme (26), chacune des portes (20 ; 120) étant disposée sur l'une de la pluralité des fentes (18 ; 118) ;
dans laquelle l'élément à mémoire de forme (26) est un élément à mémoire de forme thermique (26) ayant une température de transition, chacun des éléments à mémoire de forme (26) comprenant un enroulement à mémoire de forme, l'enroulement à mémoire de forme étant une charnière (22 ; 122) ;
dans laquelle la pluralité de portes (20 ; 120) est configurée pour être en position ouverte pour permettre à un courant d'air de refroidissement de s'écouler autour de la plaquette de circuit imprimé (14 ; 114) quand l'élément à mémoire de forme (26) est au-dessus d'une température de transition, et la pluralité de portes (20 ; 120) est configurée pour être en position fermée quand l'élément à mémoire de forme est au-dessous de sa température de transition ;
et comprenant en outre un fil conducteur (132) connectant chacun des éléments à mémoire de forme (26) à une source d'alimentation, dans laquelle la source d'alimentation (130) est configurée pour alimenter l'élément à mémoire de forme (26) au moyen du fil conducteur (132) quand une plaquette de circuit imprimé associée (14 ; 114) dépasse une température de seuil, et/ou dans laquelle la source d'alimentation (130) est configurée pour alimenter l'élément à mémoire de forme (26) au moyen du fil conducteur (132) quand la plaquette de circuit imprimé (14 ; 114) alimente un conducteur distant, et dans laquelle la mise sous tension du fil conducteur (132) provoque le chauffage résistif de l'élément à mémoire de forme (26).

2. Unité d'alimentation distante (10) selon la revendication 1, dans laquelle chacun des éléments à mémoire de forme (26) comprend un alliage nickel/titane.

3. Unité d'alimentation distante (10), selon la revendication 1 ou 2, dans laquelle chacun des éléments à mémoire de forme (26) est en contact thermique avec une plaquette de circuit imprimé associée (14 ; 114).

4. Procédé de refroidissement d'une plaquette à circuit imprimé (14 ; 114) hébergé dans une unité d'alimentation distante (10) selon une quelconque revendication précédente, le procédé comprenant :
la création d'un courant d'air de refroidissement à l'intérieur de l'unité d'alimentation distante (10) ;
la distribution d'une alimentation au moyen de la plaquette de circuit imprimé (14 ; 114) ; et
la mise sous tension du fil conducteur (132) connecté à l'élément à mémoire de forme (26) pour permettre au courant d'air de refroidissement de s'écouler autour de la plaquette de circuit imprimé (14 ; 114) quand une plaquette de circuit imprimé associée (14 ; 114) dépasse une température de seuil et/ou quand la plaquette de circuit imprimé (14 ; 114) alimente une charge distante.
